Europäisches Patentamt

European Patent Office

Office européen des brevets

(11) Numéro de publication: **0 187 560**
**B1**

(12) **FASCICULE DE BREVET EUROPEEN**

(45) Date de publication du fascicule du brevet:
02.11.89

(51) Int. Cl.⁴: **H03H 7/38**

(21) Numéro de dépôt: **85402294.4**

(22) Date de dépôt: **25.11.85**

(54) **Dispositif d'accord d'antenne haute fréquence.**

(30) Priorité: **06.12.84 FR 8418614**

(43) Date de publication de la demande:
**16.07.86 Bulletin 86/29**

(45) Mention de la délivrance du brevet:
**02.11.89 Bulletin 89/44**

(84) Etats contractants désignés:
**BE CH DE GB IT LI LU NL SE**

(56) Documents cités:
**EP-A- 0 069 979**
**DE-A- 1 516 842**
**FR-A- 878 645**
**FR-A- 2 452 827**
**US-A- 3 970 940**

(73) Titulaire: **COMMISSARIAT A L'ENERGIE ATOMIQUE,
31/33, rue de la Fédération, F-75015 Paris(FR)**

(72) Inventeur: **Raoux, Daniel, 42, rue de la Division Leclerc,
F-78830 Bonnelles(FR)**
Inventeur: **Choquer, Jean, 43 route de Chevreuse,
F-91190 Gif Sur Yvette(FR)**

(74) Mandataire: **Mongrédien, André et al, c/o
BREVATOME 25, rue de Ponthieu, F-75008 Paris(FR)**

## Description

La présente invention concerne un dispositif d'accord d'antenne dans la gamme haute fréquence.

Elle s'applique à l'accord d'une antenne haute fréquence reliée à un émetteur-récepteur capable de fournir périodiquement des signaux de puissance à des fréquences prédéterminées par une interface. Cette antenne peut être portée par un véhicule dont on veut suivre les déplacements sur un territoire, à partir d'une station de repérage, l'émetteur-récepteur fournissant les signaux mentionnés plus haut étant aussi embarqué à bord de ce véhicule. Ce type de repérage est décrit par exemple dans la demande de brevet français FR-A 8403539 déposée le 7 mars 1984 au nom du même demandeur et publiée le 13 septembre 1985, avant la date de priorité du présent document.

On sait réaliser l'accord d'une antenne haute fréquence reliée à un émetteur fournissant périodiquement des signaux à des fréquences prédéterminées par une interface ; on utilise pour cela un condensateur variable ou des condensateurs de différentes valeurs, reliés à une extrémité de l'antenne. Ces condensateurs sont commutés, en fonction de la fréquence des signaux de différentes fréquences fournis par un émetteur-récepteur. Un dispositif tel qu'il est décrit dans le préambule de la revendication principale est connu du document EP-A 0 069 979. Lorsque ces signaux présentent une puissance importante, la commutation d'un condensateur à un autre, lorsqu'elle est effectuée au cours de l'émission de ces signaux de puissance, risque de détruire les condensateurs ou même, d'endommager l'émetteur-récepteur.

L'invention a pour but de remédier à ces inconvénients et notamment de réaliser un dispositif d'accord d'antenne haute fréquence utilisant des condensateurs sélectionnés par des commutateurs actionnés par des moyens de commande de commutation qui permettent d'éviter toute commutation, lorsque l'émetteur-récepteur applique des signaux de puissance à une extrémité de l'antenne.

L'invention a pour objet un dispositif d'accord d'antenne haute fréquence, cette antenne présentant une première extrémité qui est reliée à la masse de référence, et une deuxième extrémité qui est reliée à une sortie du dispositif, un point de l'antenne, proche de la première extrémité étant relié à la sortie de puissance d'un émetteur qui fournit périodiquement des signaux de puissance émis par l'antenne à des hautes fréquences prédéterminées par une interface, le dispositif d'accord comprenant, pour chaque fréquence prédéterminée un condensateur d'accord relié à la masse de référence et à une borne d'un commutateur dont une autre borne est reliée à ladite sortie du dispositif, caractérisé en ce qu'il comprend en outre des moyens de commande des commutateurs reliés respectivement à des entrées de commande de ces commutateurs et à des sorties d'identification de fréquences de l'émetteur, chaque sortie d'identification correspondant à l'une des fréquences prédéterminées et fournissant pendant chaque période correspondant à l'émission de signaux de puissance à cette fréquence, un signal d'identification indiquant que l'émetteur fournit sur sa sortie de puissance un signal de puissance à cette fréquence, et des moyens de détection des fréquences des signaux émis par l'antenne, une sortie de ces moyens de détection étant reliée aux moyens de commande pour fournir un signal de détection interdisant toute commutation de l'un quelconque des commutateurs pendant toute la durée de chaque période d'émission des signaux de puissance à chaque fréquence prédéterminée.

Selon une autre caractéristique de l'invention, les moyens de commande comprennent, pour chaque sortie d'identification de l'émetteur, un premier transistor fonctionnant en commutation, la base de ce transistor étant reliée à la sortie d'identification de fréquence correspondante et son collecteur étant relié à une première entrée de commande d'une bascule de type D, un deuxième transistor fonctionnant en commutation, la base de ce deuxième transistor étant reliée à la sortie des moyens de détection de la puissance haute fréquence et son collecteur étant relié à une deuxième entrée de commande de la bascule, une sortie de cette bascule étant reliée à l'entrée de commande du commutateur correspondant, la sortie de cette bascule fournissant un signal de commande de commutation lorsqu'un signal d'identification de la fréquence correspondant à la sortie d'identification considérée apparaît sur cette sortie et si aucun signal de détection d'émission de signaux de puissance par l'antenne n'est présent sur la sortie des moyens de détection.

Selon une autre caractéristique, l'antenne haute fréquence étant une antenne en boucle, les moyens de détection comprennent une antenne secondaire localisée à proximité de la boucle, cette antenne secondaire étant reliée à une diode de détection, elle même reliée à un filtre dont une sortie constitue la sortie des moyens de détection.

Selon une autre caractéristique, chaque commutateur comprend un transistor fonctionnant en commutation, la base de ce transistor étant reliée à la sortie de la bascule, et un relais électromagnétique dont la bobine de commande de commutation est reliée au collecteur du transistor de commande.

Les caractéristiques et avantages de l'invention ressortiront mieux de la description qui va suivre, donnée en référence aux dessins annexés, dans lesquels :

- la figure 1 représente schématiquement un dispositif d'accord d'antenne conforme à l'invention,
- la figure 2 représente schématiquement l'un des moyens de commande des commutateurs intervenant dans le dispositif de l'invention,
- la figure 3 est une table de vérité qui permet de mieux comprendre le fonctionnement du dispositif,
- la figure 4 représente schématiquement les moyens de détection de fréquence, intervenant dans le dispositif de l'invention.

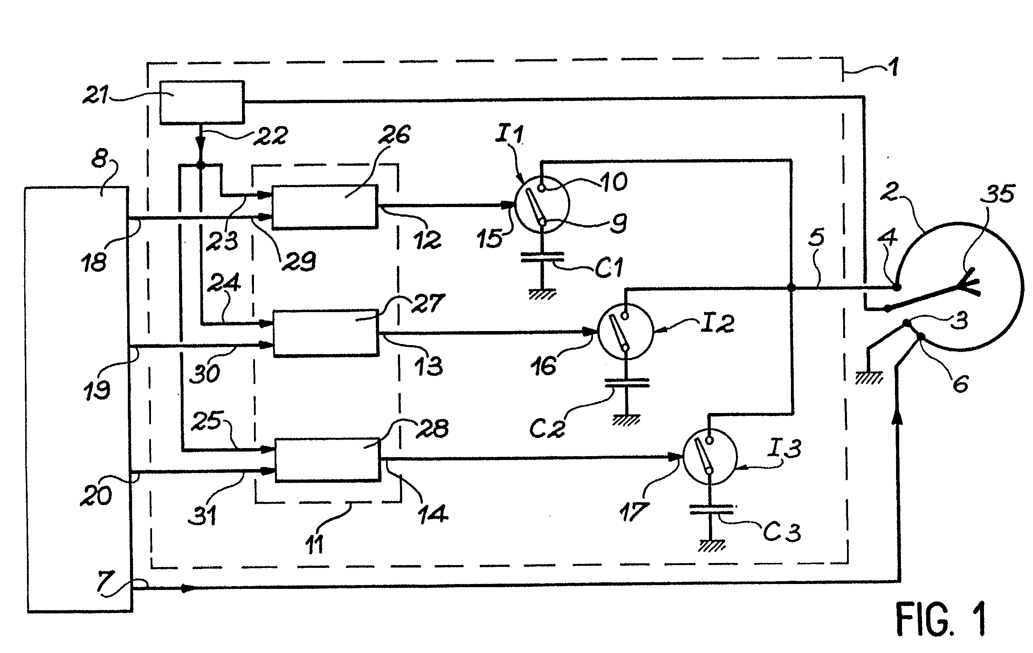

La figure 1 représente schématiquement un dispositif 1 d'accord d'antenne haute fréquence 2. Cette antenne qui, dans un mode préféré de réalisation, a la forme d'une boucle, présente une première extrémité 3 qui est reliée à la masse de référence, et une deuxième extrémité 4 qui est reliée à une sortie 5 du dispositif. Un point 6 de l'antenne, proche de la première extrémité 3 est relié à une sortie 7 de puissance, d'un émetteur 8. Cet émetteur fournit périodiquement des signaux de puissance à l'antenne, à des hautes fréquences $F_1$, $F_2$, $F_3$, respectivement pour différentes périodes prédéterminées, comme on le verra plus loin en détail. Le nombre des fréquences a été ici limité à trois, mais il est évident qu'il peut être plus élevé. Le dispositif d'accord 1 comprend pour chaque fréquence prédéterminée un condensateur d'accord relié à la masse de référence et à une borne d'un commutateur dont une autre borne est reliée à la sortie 5 du dispositif. Sur la figure, le nombre des fréquences des signaux fournis sur la sortie 7 de l'émetteur 8 ayant été limité à trois le nombre des commutateurs et des condensateurs d'accord est lui aussi limité à trois. Les condensateurs correspondant à chacune des fréquences $F_1$, $F_2$, $F_3$ sont représentés en $C_1$, $C_2$, $C_3$ et les commutateurs en $I_1$, $I_2$, $I_3$. Le condensateur $C_1$, par exemple, est relié à la masse de référence ainsi qu'à une première borne 9 du commutateur $I_1$ dont une deuxième borne 10 est reliée à la sortie 5 du dispositif. Des liaisons semblables permettent de relier respectivement les condensateurs $C_2$ et $C_3$ à la sortie 5, par l'intermédiaire des commutateurs $I_2$, $I_3$.

Le dispositif comprend aussi des moyens de commande 11 des commutateurs $I_1$, $I_2$, $I_3$. Ces moyens de commande sont respectivement reliés par des sorties 12, 13, 14 des moyens de commande 11 à des entrées de commande 15, 16, 17 des commutateurs $I_1$, $I_2$, $I_3$. Les moyens de commande 11 sont aussi reliés par des entrées 29, 30, 31 à des sorties 18, 19, 20 d'identification de fréquences, de l'émetteur 8. Ces sorties correspondent respectivement aux fréquences prédéterminées $F_1$, $F_2$, $F_3$. Chaque sortie d'identification fournit pendant chaque période correspondant à l'émission de signaux de puissance à une fréquence prédéterminée, un signal d'identification indiquant que l'émetteur fournit sur sa sortie de puissance 7 un signal de puissance à cette fréquence. C'est ainsi par exemple que la sortie 18 d'identification de l'émetteur 8 fournit un signal d'amplitude positive, lorsque l'émetteur 8 fournit sur sa sortie 7 des signaux de puissance à la fréquence $F_1$ pendant une période prédéterminée. En dehors de cette période, l'amplitude du signal sur la sortie 18 présente par exemple une valeur nulle. La sortie 19 fournit un signal d'amplitude positive pendant la période où l'émetteur 8 fournit sur sa sortie de puissance 7 un signal de puissance à la fréquence $F_2$. Enfin, la sortie 20 fournit un signal d'amplitude positive pendant la période d'émission de signaux de puissance, à la fréquence $F_3$, sur la sortie 7 de l'émetteur 8.

Enfin, le dispositif comprend des moyens 21 de détection des fréquences des signaux émis par l'antenne 2. Une sortie 22 de ces moyens de détection est reliée à des entrées 23, 24, 25 des moyens de commande 11. Comme on le verra plus loin en détail, ces moyens de détection 21 fournissent, lorsque l'antenne 2 émet des signaux de haute fréquence, un signal de détection qui interdit toute commutation de l'un quelconque des commutateurs $I_1$, $I_2$, $I_3$ pendant toute la durée de chaque période d'émission des signaux de puissance, à chaque fréquence prédéterminée. Les moyens de commande 11 comprennent pour chacune des sorties 18, 19, 20 d'identification un circuit de commande. Ces circuits de commande sont représentés en 26, 27, 28 sur la figure. Les sorties d'identification 18, 19, 20 sont respectivement reliées aux entrées 29, 30, 31 des circuits de commande 26, 27, 28.

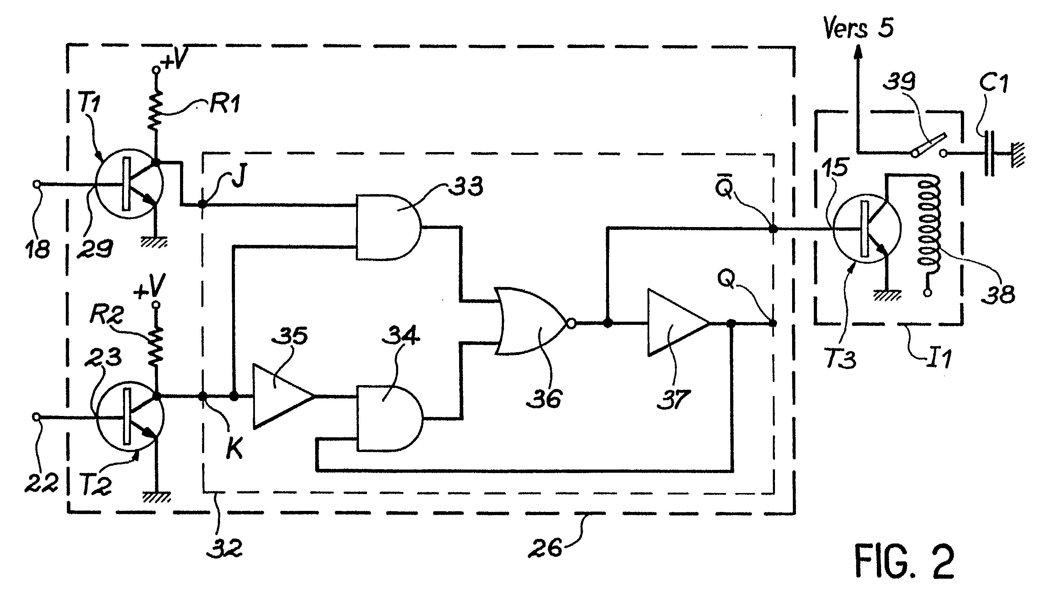

La figure 2 représente schématiquement l'un des circuits de commande (26 par exemple) appartenant aux moyens de commande 11 de la figure 1. Les circuits de commande 26, 27, 28 sont identiques.

Le circuit de commande (26 par exemple) comprend un premier transistor $T_1$ fonctionnant en commutation; la base de ce transistor est reliée à la sortie 18 correspondante de l'émetteur 8 et son collecteur est relié à une première entrée J d'une bascule 32 du type D ; l'émetteur est relié à la masse de référence, tandis que le collecteur est aussi relié par une résistance $R_1$ à une source de tension positive +V. Ce transistor fonctionne en commutation et sa base constitue l'entrée 29 des moyens de commande 11. Le circuit de commande 26 comprend aussi un deuxième transistor $T_2$ fonctionnant en commutation ; la base de ce transistor est reliée à la sortie 22 des moyens de détection 21 et elle constitue l'entrée 23 des moyens de commande 11. Le collecteur de ce transistor est relié à une autre entrée K de la bascule 32. Ce collecteur est aussi relié à la source de tension positive +V par une résistance $R_2$. L'émetteur du transistor $T_2$ est relié à la masse de référence. La sortie Q de la bascule 32 est reliée à l'entrée de commande 15 du commutateur correspondant $I_1$. La sortie Q fournit un signal de commande de commutation, si un signal d'identification de la fréquence $F_1$ apparaît sur la sortie d'identification 18 de l'émetteur 8, et si aucun signal de détection d'émission de signaux de puissance par l'antenne, n'est présent sur la sortie 22 des moyens de détection 21. Le fonctionnement de ce circuit sera décrit plus loin en détail. La bascule 32 de type D, qui est bien connue dans l'état de la technique comprend par exemple une première porte ET, 33, dont une entrée constitue l'entrée J de cette bascule et dont une autre entrée est reliée à l'entrée K de la bascule. Cette bascule comprend aussi une deuxième porte ET, 34, dont une entrée est reliée à la sortie d'un amplificateur 35, lui-même relié à l'entrée K de la bascule. Une autre entrée de la porte 34 est reliée à la sortie directe Q de la bascule. Les sorties des portes 33 et 34 sont reliées aux entrées d'une porte OU 36, à sortie inversée. La sortie de la porte OU 36 est reliée à l'entrée d'un amplificateur 37 dont la sortie constitue la sortie directe Q de la bascule.

On a aussi représenté sur cette figure le commutateur I1 commandé sur son entrée 15 par le signal apparaissant sur la sortie Q de la bascule 32. Cette sortie Q constitue la sortie 12 des moyens de commande 11. Le commutateur $I_1$ comprend un transistor $T_3$ dont la base constitue l'entrée de commande du commutateur ; ce transistor fonctionne en commutation. Son émetteur est relié à la masse de référence tandis que son collecteur est relié à la bobine de commande 38 d'un relais 39. L'une des bornes de ce relais est reliée au condensateur d'accord $C_1$, tan-

dis que l'autre borne de ce relais est reliée à la sortie 5 du dispositif.

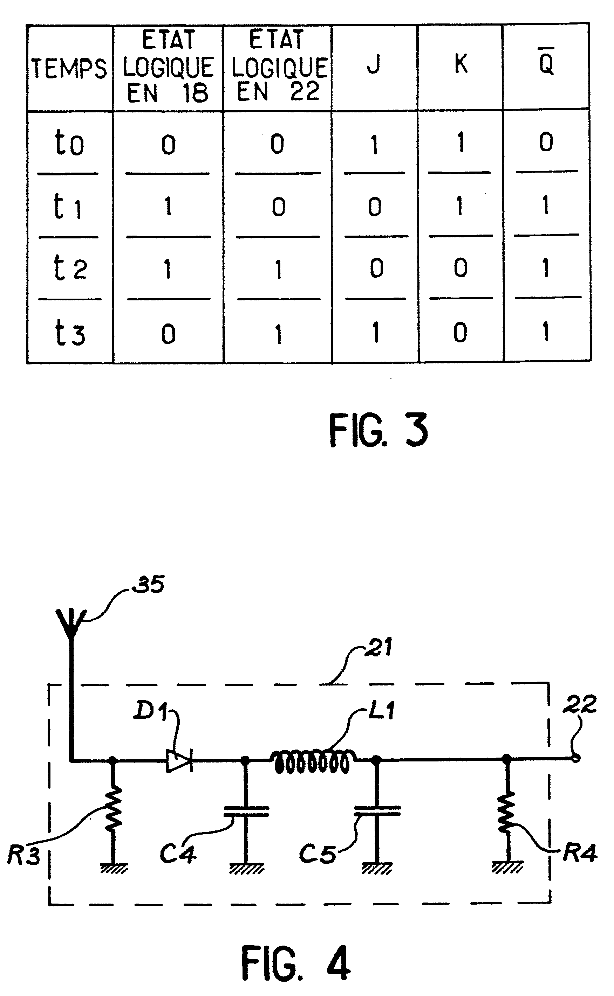

La table de vérité de la figure 3 va maintenant permettre de mieux comprendre le fonctionnement des moyens de commande 11. Cette table de vérité s'applique ici au fonctionnement du circuit 26 de la figure 2. Il est bien évident que le fonctionnement des circuits 27 et 28 se déduit facilement du fonctionnement du circuit 26. Dans cette table, on considère différents instants $t_0$, $t_1$, $t_2$, $t_3$ de fonctionnement du circuit 26. On suppose qu'une amplitude positive des signaux fournis sur la sortie d'identification 18 (indiquant une émission à la fréquence $F_1$) correspond à un état logique 1, tandis qu'une amplitutude nulle de ce signal correspond à un état logique 0 (aucune émission à la fréquence $F_1$). De la même manière, on suppose qu'une amplitude positive du signal fourni sur la sortie 22 des moyens de détection 21, correspond à un état logique 1 (détection de signaux émis par l'antenne), tandis qu'une amplitude nulle correspond à un état logique 0 (aucun signal émis par l'antenne). On a également indiqué dans ce tableau les états logiques des signaux présents sur les entrées J et K de la bascule 32, ainsi que les états logiques des signaux sur la sortie Q de la bascule 32.

Si à l'instant $t_0$, l'émetteur ne fournit aucun signal de puissance à la fréquence $F_1$, l'état logique du signal sur la sortie d'identification 18 est 0. De la même manière, si aucune émission de puissance n'est détectée par les moyens de détection 21, l'état logique du signal sur la sortie 22 de ces moyens est aussi 0. Il en résulte que les entrées J et K de la bascule 32 sont au niveau logique 1 et que la sortie Q de la bascule 32 est au niveau logique 0. Le relais 39 des moyens de commutation $I_1$ est donc ouvert.

Si à l'instant $t_1$, l'émetteur 8 fournit un signal d'identification de la fréquence $F_1$, le signal sur la sortie d'identification 18 passe à l'état logique 1. Si aucune émission de puissance par l'antenne n'est détectée par les moyens de détection 21, l'état logique de la sortie 22 de ces moyens est encore 0. Il en résulte que les signaux appliqués sur les entrées J et K présentent respectivement les états logiques 0 et 1 ; la sortie Q de la bascule 32 présente alors l'état logique 1. Le relais 39 du commutateur $I_1$ est donc fermé à l'instant $t_1$.

Si l'instant $t_2$, l'émetteur commence à fournir des signaux de puissance à la fréquence $F_1$, et si donc une émission de puissance est détectée par les moyens 21, les sorties 18 et 22 de l'émetteur 8 et des moyens de détection 21 sont à l'état logique 1, il en résulte que les entrées J et K de la bascule 32 sont à l'état logique 0. La sortie Q de la bascule 32 reste à l'état logique 1 qui maintient la fermeture du relais 39.

Enfin, à l'instant $t_3$, si le signal d'identification à la fréquence $F_1$ disparait, la sortie d'identification 18 de l'émetteur 8 passe à l'état logique 0. Si une émission de puissance sur l'antenne est détectée par les moyens de détection 21, la sortie 22 de ces moyens de détection reste à l'état logique 1 et il en résulte que les entrées J et K de la bascule 32 sont respectivement dans les états logiques 1 et 0. La sortie Q de cette bascule reste donc à l'état logique 1.

On voit donc que la fermeture du relais 39 ne peut être commandée que si aucune émission de puissance n'est détectée par les moyens 21. Ceci résulte d'une propriété bien connue d'une bascule de type D, à savoir que si l'entrée K de cette bascule est à zéro, sa sortie Q ne peut pas changer d'état, même si l'état de son entrée J change.

Le fonctionnement des circuits 27 et 28 pourrait être expliqué de la même manière.

La figure 4 représente schématiquement les moyens de détection 21, dont la sortie 22 fournit un signal d'amplitude positive lorsque l'antenne émet des signaux de puissance. Ces moyens de détection comprennent une antenne secondaire 35 reliée à une diode de détection $D_1$, elle-même reliée à un filtre constitué de manière connue par une inductance $L_1$ dont les extrémités sont reliées respectivement à des condensateurs $C_4$, $C_5$, eux-mêmes reliés à la masse de référence. Des résistances $R_3$, $R_4$ relient respectivement l'antenne secondaire 35 et la sortie 22 à la masse de référence. Ces résistances permettent de fixer l'impédance de l'antenne secondaire.

## Revendications

1. Dispositif (1) d'accord d'antenne haute fréquence (2), cette antenne présentant une première extrémité (3) qui est reliée à une masse de référence, et une deuxième extrémité (4) qui est reliée à une sortie (5) du dispositif (1), un point (6) de l'antenne, proche de la première extrémité (3) étant relié à une sortie (7) de puissance d'un émetteur (8) qui fournit au cours de différentes périodes intermittentes des signaux de puissance émis par l'antenne respectivement à des hautes fréquences ($F_1$, $F_2$, $F_3$, . . .) prédéterminées respectivement pour ces différentes périodes, le dispositif d'accord (1) comprenant, pour chaque fréquence prédéterminée ($F_1$ ou $F_2$ ou $F_3$, . . .), un condensateur d'accord ($C_1$ ou $C_2$ ou $C_3$, . . .) relié à la masse de référence et à une borne (9) d'un commutateur ($I_1$ ou $I_2$ ou $I_3$, . . .) dont une autre borne (10) est reliée à ladite sortie (5) du dispositif, caractérisé en ce qu'il comprend en outre des moyens de commande (11) des commutateurs ($I_1$, $I_2$, $I_3$) reliés respectivement à des entrées de commande (15, 16, 17) de ces commutateurs, et à des sorties d'identification (18, 19, 20) de fréquences ($F_1$, $F_2$, $F_3$) de l'émetteur (8), chaque sortie d'identification correspondant à l'une des fréquences prédéterminées ($F_1$, $F_2$, $F_3$) et fournissant pendant chaque période correspondant à l'émission de signaux de puissance à cette fréquence un signal d'identification indiquant que l'émetteur (8) fournit sur sa sortie (7) de puissance un signal de puissance à cette fréquence, et des moyens (21) de détection des fréquences ($F_1$, $F_2$, $F_3$) des signaux de puissance émis par l'antenne (2), une sortie (22) de ces moyens de détection étant reliée aux moyens de commande (11), pour fournir un signal de détection interdisant toute commutation de l'un quelconque des commutateurs ($I_1$, $I_2$, $I_3$) pendant toute la durée de chaque période d'émission des signaux de puissance à chaque fréquence prédéterminée.

2. Dispositif selon la revendication 1, caractérisé en ce que les moyens de commande (11) comprennent, pour chaque sortie (18 ou 19 ou 20) d'identification de l'émetteur (8), un premier transistor (T₁) fonctionnant en commutation, la base de ce transistor étant reliée à la sortie d'identification (18) correspondante et son collecteur étant relié à une première entrée de commande (J) d'une bascule (32) de type D, un deuxième transistor (T₂) fonctionnant en commutation, la base de ce deuxième transistor étant reliée à la sortie (22) des moyens de détection (21) des signaux de puissance et son collecteur étant relié à une deuxième entrée de commande (K) de la bascule (32), une sortie (Q) de cette bascule (32) étant reliée à l'entrée de commande (15) du commutateur (I₁) correspondant, la sortie de cette bascule fournissant un signal de commande de commutation lorsqu'un signal d'identification de la fréquence (F₁) correspondant à la sortie d'identification (18) considérée apparaît sur cette sortie et si aucun signal de détection d'émission de signaux de puissance par l'antenne n'est présent sur la sortie (22) des moyens de détection (21).

3. Dispositif selon la revendication 2, caractérisé par le fait que l'antenne haute fréquence (2) étant une antenne en boucle, les moyens de détection (21) comprennent une antenne secondaire (35) localisée à proximité de la boucle, cette antenne secondaire étant reliée une diode (D₁) de détection, elle-même reliée à un filtre (L₁, C₄, C₅) dont une sortie (22) constitue la sortie des moyens de détection.

4. Dispositif selon la revendication 2, caractérisé en ce que chaque commutateur (I₁, I₂, I₃) comprend un transistor de commande (T₃) fonctionnant en commutation, la base de ce transistor étant reliée à la sortie (Q) de la bascule (32), et un relais électromagnétique (39) dont une bobine de commande (38) de commutation est reliée au collecteur du transistor de commande (T₃).

## Patentansprüche

1. Anpassungsanordnung (1) für HF-Antenne (2), wobei diese Antenne ein erstes Ende (3) aufweist, das mit einer Referenzmasse verbunden ist, und ein zweites Ende (4) aufweist, das mit einem Ausgang (5) der Anordnung (1) verbunden ist, wobei ein Punkt (6) der Antenne, in der Nähe des ersten Endes (3) mit einem Leistungsausgang (7) eines Senders (8) verbunden ist, der während unterschiedlicher intermittierender Perioden Leistungssignale liefert, die durch die Antenne bei entsprechenden hohen Frequenzen (F₁, F₂, F₃, . . .) gesendet werden, die entsprechend vorbestimmt sind für diese unterschiedlichen Perioden, wobei die Anpassungsanordnung (1) für jede vorbestimmte Frequenz (F₁ oder F₂ oder F₃, . . .) einen Anpassungskondensator (C₁ oder C₂ oder C₃, . . .) der mit der Referenzmasse und einem Anschluß (9) eines Schalters (I₁ oder I₂ oder I₃, . . .) verbunden ist, von dem ein anderer Anschluß (10) mit dem Ausgang (5) der Anordnung verbunden ist, dadurch gekennzeichnet, daß er weiterhin Befehlseinrichtungen (11) der Schalter (I₁, I₂, I₃) aufweist, die entsprechend mit Befehlseingängen (15, 16, 17) dieser Schalter verbunden sind, und mit Identifikationsausgängen (18, 19, 20) der Frequenz (F₁, F₂, F₃) des Senders (8) verbunden sind, wobei jeder Identifikationsausgang einer der vorbestimmten Frequenzen (F₁, F₂, F₃) entspricht und während jeder Periode, die dem Ausgeben des Leistungssignals bei dieser Frequenz entspricht, ein Identifikationssignal liefert, das angibt, daß der Sender (8) auf seinem Leistungsausgang (7) ein Leistungssignal dieser Frequenz liefert, und Erfassungseinrichtungen (21) der Frequenzen (F₁, F₂, F₃) der Leistungssignale aufweist, die von der Antenne (2) ausgegeben werden, wobei ein Ausgang (22) dieser Erfassungseinrichtung mit den Befehlseinrichtungen (11) verbunden ist, um ein Erfassungssignal zu liefern, das jede Schaltung eines jeglichen der Schalter (I₁, I₂, I₃) während der gesamten Dauer einer jeden Periode des Leistungssignalausgebens bei jeder vorbestimmten Frequenz verbietet.

2. Anordnung nach Anspruch 1, dadurch gekennzeichnet, daß die Befehlseinrichtungen (11) für jeden Identifizierungsausgang (18 oder 19 oder 20) des Senders (8) einen ersten Transistor (T₁), der beim Umschalten wirkt, aufweisen, wobei die Basis dieses Transistors mit dem zugehörigen Identifikationsausgang (18) verbunden ist und sein Kollektor mit einem ersten Befehlseingang (J) einer Kippschaltung (32) vom Typ D verbunden ist, ein zweiter Transistor (T₂) beim Umschalten wirkt, wobei die Basis dieses zweiten Transistors mit dem Ausgang (22) der Erfassungseinrichtungen (21) der Leistungssignale verbunden ist und sein Kollektor mit einem zweiten Befehlseingang (K) der Kippschaltung (32) verbunden ist, wobei ein Ausgang (Q) dieser Kippschaltung (32) mit dem Befehlseingang (15) des Umschalters (I₁) entsprechend verbunden ist, wobei der Ausgang dieser Kippschaltung, die ein Befehlsumschaltungssignal liefert, wenn ein Identifikationssignal der Frequenz (F₁) entsprechend dem betreffenden Identifikationsausgang (18) an diesem Ausgang erscheint und wenn kein Erfassungssignal des Senders von Leistungssignalen durch die Antenne am Ausgang (22) der Erfassungseinrichtungen (21) vorliegt.

3. Anordnung nach Anspruch 2, dadurch gekennzeichnet, daß die HF-Antenne (2) eine Spulenantenne ist, die Erfassungseinrichtungen (21) eine Sekundärantenne (35) aufweisen, die in der Nähe der Spule angeordnet ist, wobei diese Sekundärantenne mit einer Erfassungsdiode (D₁) verbunden ist, wobei diese selbst mit einem Filter (L₁, C₄, C₅) verbunden ist, dessen einer Ausgang (22) den Ausgang der Erfassungseinrichtungen bildet.

4. Anordnung nach Anspruch 2, dadurch gekennzeichnet, daß jeder Umschalter (I₁, I₂, I₃) einen Befehlstransistor (T₃), der beim Umschalten wirkt, wobei die Basis dieses Transistors mit dem Ausgang (Q) des Kippschaltkreises (32) verbunden ist, und ein elektromagnetisches Relais (39) aufweist, von dem eine Befehlsspule (38) der Umschaltung mit dem Kollektor des Befehlstransistors (T₃) verbunden ist.

## Claims

1. High frequency (2) antenna tuning device (1), in which the antenna has a first end (3) which is connected to reference earth and a second end (4) connected to the output (5) of the device (1), one point (6) of the antenna close to the first end (3) being connected to the power output (7) of a transmitter (8), which during different intermittent periods supplies power signals transmitted by the antenna at high frequencies ($F_1$, $F_2$, $F_3$, etc.) respectively predetermined for these different periods, the tuning device (1) having for each predetermined frequency ($F_1$ or $F_2$ or $F_3$, etc.) a tuning capacitor ($C_1$ or $C_2$ or $C_3$, etc.) connected to the reference earth and to one terminal (9) of a switch ($I_1$ or $I_2$ or $I_3$, etc.), whereof another terminal (10) is connected to said output (5) of the device, characterized in that it also comprises means (11) for controlling the switches ($I_1$, $I_2$, $I_3$) respectively connected to the control inputs (15, 16, 17) of said switches and to frequency ($F_1$, $F_2$, $F_3$) identification outputs (18, 19, 20) of the transmitter (8), each identification output corresponding to one of the predetermined frequencies ($F_1$, $F_2$, $F_3$) and supplying during each period corresponding to the transmission of power signals at said frequency, an identification signal indicating that the transmitter (8) is supplying on its power output (7) a power signal at said frequency, as well as means (21) for detecting the frequencies ($F_1$, $F_2$, $F_3$) of the signals transmitted by the antenna (2), one output (22) of said detection means being connected to the control means (11) for supplying a detection signal preventing any switching of any random one of the switches ($I_1$, $I_2$, $I_3$) throughout the duration of each period of transmitting power signals at each predetermined frequency.

2. Device according to claim 1, characterized in that the control means (11) comprise, for each identification output (18 or 19 or 20) of the transmitter (8), a first transistor ($T_1$) operating in the switching mode, the base of the transistor being connected to the corresponding frequency identification output (18) and its collector being connected to a first control input (J) of a type D flip-flop (32), a second transistor ($T_2$) operating in the switching mode, the base of said second transistor being connected to the output (22) of the high frequency power detection means (21) and its collector being connected to a second control input (K) of the flip-flop (32), an output (Q) of the latter being connected to the control input (15) of the switch ($I_1$), the output of said flip-flop supplying a switching control signal when an identification signal of the frequency ($F_1$) corresponding to the identification output (18) in question appears on said output and if no signal for the detection of transmission of power signals by the antenna is present on the output (22) of the detection means (21).

3. Device according to claim 2, characterized in that the high frequency antenna (2) is a loop antenna, so that the detection means (21) incorporate a secondary antenna (35) positioned in the vicinity of the loop, said secondary antenna being connected to a detection diode ($D_1$), which is itself connected to a filter ($L_1$, $C_4$, $C_5$), whose output (22) constitutes the output of the detection means.

4. Device according to claim 2, characterized in that each switch ($I_1$, $I_2$, $I_3$) comprises a control transistor ($T_3$) operating in the switching mode, the base of said transistor being connected to the output (Q) of the flip-flop (32), as well as an electromagnetic relay (39), whereof a switching control coil (38) is connected to the collector of the control transistor ($T_3$).

FIG. 1

FIG. 2

EP 0 187 560 B1

| TEMPS | ETAT LOGIQUE EN 18 | ETAT LOGIQUE EN 22 | J | K | $\overline{Q}$ |
|-------|-------------------|--------------------|---|---|----------------|
| $t_0$ | 0 | 0 | 1 | 1 | 0 |
| $t_1$ | 1 | 0 | 0 | 1 | 1 |
| $t_2$ | 1 | 1 | 0 | 0 | 1 |
| $t_3$ | 0 | 1 | 1 | 0 | 1 |

# FIG. 3

# FIG. 4